Europäisches Patentamt

(19) European Patent Office

Office européen des brevets

(11) Publication number: **0 082 773**
**A2**

(12) **EUROPEAN PATENT APPLICATION**

(21) Application number: **82402309.7**

(22) Date of filing: **16.12.82**

(51) Int. Cl.³: **H 03 K 19/096**

(30) Priority: **17.12.81 US 308072**

(43) Date of publication of application:
**29.06.83 Bulletin 83/26**

(84) Designated Contracting States:
**DE FR GB IT NL**

(71) Applicant: **FAIRCHILD CAMERA & INSTRUMENT
CORPORATION
464 Ellis Street
Mountain View California 94042(US)**

(72) Inventor: **Davies, Thomas J., Jr.
2870 Deeva Court
Gilroy California 95020(US)**

(74) Representative: **Chareyron, Lucien et al,
Schlumberger Limited 42, rue Saint-Dominique
F-75340 Paris Cedex 07(FR)**

(54) Apparatus and method for CMOS multistaged dynamic logic circuit.

(57) A dynamic logic circuit comprising a plurality of logic structures having different conductivity types coupled alternately in series is described. All stages of the dynamic logic circuit are precharged simultaneously. An evaluation signal applied to the first stage will cause the first stage to move from its precharged level to an active level. If the input conditions of the first and all succeeding stages are met, the first and all of the succeeding stages will begin to evaluate as each preceding stage moves through the threshold of the succeeding stage.

FIG. 1

EP 0 082 773 A2

APPARATUS AND METHOD FOR CMOS MULTISTAGED
DYNAMIC LOGIC CIRCUIT

The present invention relates to logic circuits in general
and in particular to the implementing of many levels of logic in a
CMOS process without having to use fully complimentary logic.

BACKGROUND OF THE INVENTION

In a single channel process only a single level of dynamic
logic can be implemented within one clock time.  The reason being
that the precharged level is the active level.

In a 1981 IEEE International Solid State Circuits
Conference Report, page 230, there is described a dynamic VLSI logic
circuit comprising a plurality of N channel logic structures.  Each
of the logic structures are interconnected by an inverter.,  The
speed of the prior known VLSI logic circuit is determined by the
time it takes for the signal applied to the first input to propagate
through the circuit to the last logic structure.  Only the first of
the prior known logic structures is precharged.

SUMMARY OF THE INVENTION

A general object of the present invention is to provide a
method and apparatus for implementing multiple levels of logic
comprising different types of conductivity.

This and other objects are attained, in accordance with one
aspect of the invention by a method of making a dynamic logic
circuit comprising the steps of:  providing in each one of a
plurality of logic structures of a first and a second conductivity
type, a means for precharging said logic structure; providing in
each one of said logic structures a means for changing said logic
structure from a precharged state to an active state; coupling said
changing means of one of said plurality of logic structures, other
than a first one of said logic structures, of said first
conductivity type to an output of one of said plurality of logic
structures of said second conductivity type so that said logic
structures of said first and said second conductivity type are
coupled alternately in series; providing in said changing means of
said first one of said logic structures of said first conductivity type a means responsive to an evaluation signal for changing said first one of said logic structures of said first conductivity type and succeeding logic structures of said first and said second conductivity type from their precharged state to their active state.

Another aspect of the invention includes a dynamic logic circuit comprising: means in each one of a plurality of logic structures of a first and a second conductivity type for precharging said logic structure; means for changing said logic structures from a precharged state to an active state; means for coupling said plurality of logic structures, other than a first one of said logic structures, of said first conductivity type to an output of one of said plurality of logic structures of said second conductivity type so that said logic structures of said first and said second conductivity types are coupled alternately in series; means, in said changing means of said first one of said logic structures of said first conductivity type, responsive to an evaluation signal for changing said first one of said logic structures of said first conductivity type and succeeding logic structures of said first and said second conductivity type from their precharged state to their active state.

The above and other objects, features and advantages of the present invention will become apparent from the following detailed description of the accompanying drawing, in which

Fig. 1 is a block diagram of a generalized logic circuit according to the present invention.

Fig. 2 is a block diagram of an inverter according to the present invention.

Fig. 3 is a schematic of the conventional CMOS inverter.

Fig. 4 is a schematic of a conventional CMOS NAND gate.

Fig. 5 is a schematic of a dynamic N channel NAND gate according to the present invention.

Fig. 6 is a schematic of a dynamic P-channel NAND gate according to the present invention.

Fig. 7 is a schematic of a conventional CMOS NOR gate.

Fig. 8 is a schematic of a dynamic N-channel NOR gate according to the present invention.

Fig. 9 is a dynamic P channel NOR gate according to the present invention.

Fig. 10 is a block diagram of four series coupled inverters.

Fig. 11 is a schematic of a conventional CMOS **0082773** implementation of the circuit of Fig. 8.

Fig. 12 is a block diagram of series coupled inverters according to the present invention.

Fig. 13 is a schematic of an N channel and a P channel embodiment of the circuit of Fig. 10 according to the present invention.

Fig. 14 is a block diagram of a complex logic circuit according to the present invention.

Fig. 15 is a schematic diagram of an N channel and P channel dynamic logic circuit embodiment of the circuit of Fig. 14 according to the present invention.

Fig. 16 is a timing diagram of five stages of logic according to the present invention.

## DETAILED DESCRIPTION OF THE INVENTION

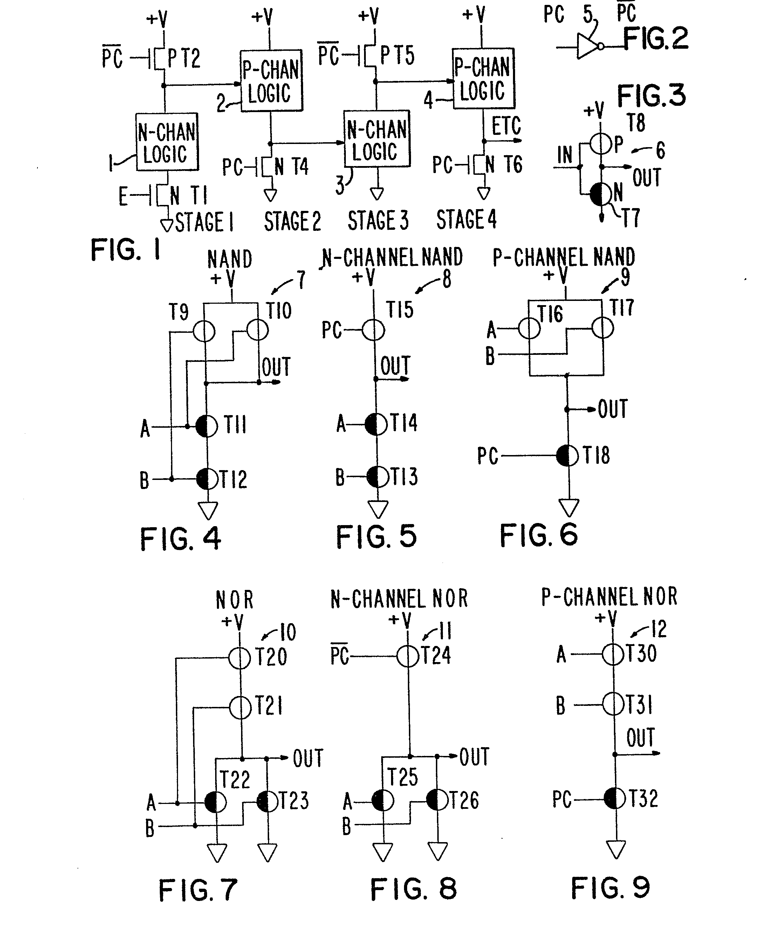

Referring to Fig. 1, there is provided, in accordance with the present invention, an N channel logic structure 1. Coupled between the logic structure 1 and ground there is provided an N-channel MOS transistor T1. Coupled to the gate of the transistor T1 there is provided a source of an evaluation signal (not shown) for providing an evaluation signal E. Coupled between the logic structure 1 and a source of positive voltage +V there is provided a P-channel MOS transistor T2. Coupled to the gate of T2 there is provided a source of a precharge signal $\overline{PC}$. The output node of the logic structure 1 is located between T2 and the logic structure 1.

Coupled to the output node of the logic structure 1 there is provided a P-channel logic structure 2. Coupled between the logic structure 2 and ground there is provided an N-channel MOS transistor T4 coupled to the gate of the transistor T4 there is provided a source of a precharge signal PC. The logic structure 2 is also coupled to a source of positive voltage +V. The output node of the logic structure 2 is located between the logic structure 2 and the transistor 4.

Coupled to the output node of the logic structure 2, there is provided an N-channel logic structure 3. The logic structure 3 is coupled to ground and to a source of positive voltage +V. Between the source of positive voltage +V and the logic structure 3 there is provided a P-channel MOS transistor T5. Coupled to the gate of the transistor T5 is the source of the precharged signal $\overline{PC}$. The output node of the logic structure 3 is located between the transistor T5 and logic structure 3.

Coupled to the output node of the logic structure 3 there is provided a P channel logic structure 4. The P channel logic structure 4 is coupled between the source of positive voltage +V and ground. Coupled between the logic structure 4 and ground there is provided an N-channel MOS transistor T6. Coupled to the gate of the transistor T6 there is provided the source of the precharge signal PC. The output node of the logic structure 4 is coupled between the logic structure 4 and the transistor T6.

As described above with respect to stages 1, 2, **0082773**
3 and 4 of Fig. 1, additional stages may be coupled
to the output node of the logic structure 4.

Referring to Fig. 2 there is provided an inverter
5. The inverter 5 is coupled to a source of the
precharged signal PC for providing on its output the
precharge signal $\overline{PC}$. It is understood however that
inverter 5 is only one of several ways to generate
the necessary precharge signals.

Referring to Fig. 3 there is shown a schematic
of a conventional CMOS inverter 6. Inverter 6
comprises an N-channel or more commonly called NMOS
transistor T7 and a P-channel or as more commonly
called PMOS transistor T8. Transistors T7 and T8 are
coupled between a source of positive voltage +V and
ground. The input of the transistor 6 is coupled to
the gates of T7 and T8 and designated in. The output
of the transistor 6 is taken from a nodal point
between the transistors T7 and T8 and designated out.

Referring to Fig. 4 there is shown a NAND gate 7
implemented with conventional CMOS technolgy. In
gate 7 there is provided two PMOS transistors T9 and
T10 and two NMOS transistors T11 and T12. The
transistors T9 and T10 are coupled in parallel and
transistors T11 and T12 are coupled in series. The
series coupled transistors T11 and T12 are, in turn,
coupled to ground in series with the parallel transistors T9 and T10. Two inputs A and B are coupled
to the gates of T9 - T12. The output node is coupled
between the transistors T9 and T10 and the transistor

T11.

Referring to Fig. 5 there is provided in accordance with the present invention a dynamic NAND gate 8 which is implemented according to the present invention.

In NAND gate 8 there is provided a pair of series coupled NMOS transistors T13 and T14 and a PMOS transistor T15 coupled between a source of positive voltage +V and ground. A pair of inputs A and B are coupled to the gates of the transistors T13 and T14. The precharge signal PC is coupled to the gate of the transistor T15. The output of the NAND gate is taken from a nodal point located between the drain and source of the transistors T15 and T14.

Referring to Fig. 6 there is provided in accordance with the present invention a dynamic P-channel NAND gate 9. In the NAND gate 9 there is provided coupled between a source of positive voltage +V and ground a pair of PMOS transistors T16 and T17 coupled in parallel and an NMOS transistor T18 coupled in series therewith. The gates of transistors T16 and T17 are coupled to a source of inputs A and B. The gate of transistor T18 is coupled to a source of precharge voltage PC. The output of the NAND gate 9 is coupled to a nodal point between the transistors T16 and T17 and the transistor T18.

It can be seen from a comparison of the circuits in Figs. 5 and 6 that the dynamic N-channel NAND gate 8 comprises a conventional CMOS NAND gate as shown in Fig. 4 with the PMOS transistors T9 and T10 replaced by a PMOS transistor T15 having a precharge signal PC coupled to its gate. Similarly the dynamic P-channel NAND gate 9 of Fig. 6 is made from a conventional CMOS NAND gate as shown in Fig. 4 by replacing the NMOS transistors T11 and T12 with the NMOS transistor T18 with a precharge signal PC coupled to the gate thereof.

Referring to Fig. 7 there is shown a NOR gate 10 which is made using conventional CMOS technology. In the NOR gate 10 there is provided a pair of series coupled PMOS transistors T20 and T21. Coupled in series with the transistors T20 and T21 there is provided a pair of parallel coupled NMOS transistors T22 and T23. A pair of inputs A and B are coupled to the gates of the transistors T20 - T23. The output of the gate 10 is taken from a nodal point between the transistors T20 and T21 and the transistors T22 and T23.

Referring to Fig. 8 there is provided in accordance with the present invention an N-channel NOR gate 11. In the NOR gate 11 there is provided coupled between a source of positive voltage +V and ground a PMOS transistor T24 coupled in series with a pair of parallel coupled NMOS transistors T25 and T26. A pair of inputs A and B are coupled to the gates of the transistors T25 and T26 and a source of precharge voltage $\overline{PC}$ is coupled to the gate of the transistor T24. The output of the gate 11 is taken from a nodal point located between the transistor T24 and the transistors T25 and T26.

Referring to Fig. 9 there is provided in accordance with the present invention a dynamic P-channel NOR gate 12. In the gate 12 there is provided a pair of PMOS transistors T30 and T31 coupled in series. The transistors T30 and T31 are coupled in series with an NMOS transistor T32. A pair of inputs A and B are coupled to the gates of the transistors T30 and T31 and a source of precharge voltage PC is coupled to the gate of the transistor T32. The output of the gate 12 is taken from a nodal point located between the transistors T30 and T31 and the transistor T32.

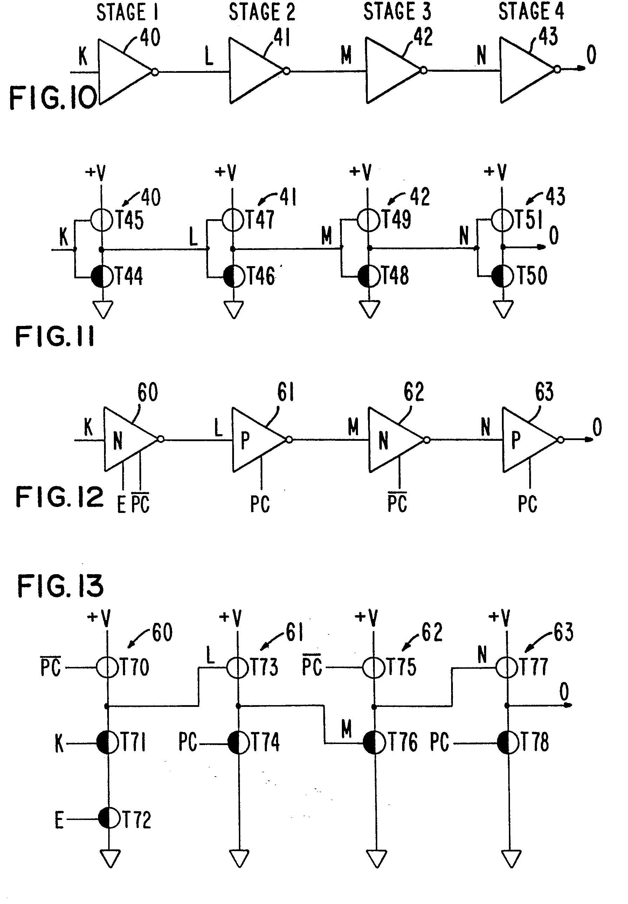

Referring to Fig. 10 there is shown a block diagram comprising four inverters 40, 41, 42 and 43 coupled in series. Inverter 40 is provided with an input K. The output of inverter 40 is coupled to an input L of the inverter 41. The output of the inverter 41 is coupled to an input M of the inverter 42. The output of inverter 42 is coupled to an input N of the inverter 43. The inverter 43 is provided with an output O.

Referring to Fig. 11, there is shown an embodiment of the circuit of Fig. 10 using conventional CMOS technology. In the inverter 40 there is provided coupled in series between a source of positive voltage +V and ground an NMOS transistor T44 and a PMOS transistor T45. The input K is coupled to the gates of the transistors T40 and T45. The output of the inverter 40 is taken from a nodal point located between the transistor T44 and T45.

In the inverter 41 there is provided coupled between a source of positive voltage +V and ground an NMOS transistor T46 and a PMOS transistor T47. The input L to the inverter 41 is coupled to the output of the inverter 40. The output of the inverter 41 is taken from a nodal point located between the transistors T46 and T47.

In the inverter 42 there is provided, coupled in series between a source of positive voltage +V and ground, an NMOS transistor T48 and a PMOS transistor T49. The input M to the inverter 42 is coupled to the gates of the transistors T48 and T49 and to the output of the inverter 41.

In the inverter 43 there is provided, coupled in series between a source of positive voltage +V and ground, an NMOS transistor T50 and a PMOS transistor T51. The input N of the inverter 43 is coupled to the gates of the transistors T50 and T51 and to the output of the inverter 42. The output O of the inverter 43 is made available for coupling to additional logic circuits.

Referring to Fig. 12 there is shown a block diagram of a dynamic logic circuit embodiment of the circuit of Fig. 10. In accordance with the present invention there is provided in the circuit of Fig. 12 and N-channel inverter 60, a P channel inverter 61, an N-channel inverter 62 and a P channel inverter 63. The N-channel inverter 60 is provided with an input K. The output of inverter 60 is coupled to an input L of the inverter 61. The output of inverter 61 is coupled to an input M of the inverter 62. The output of the inverter 62 is coupled to an input N of the inverter 63 and the output O of the inverter 63 is made available for coupling to additional logic circuits.

Each of the inverters 60 - 63 of Fig. 12 is further provided with a precharge voltage signal. The inverters 60 and 62 are provided with a precharge voltage signal $\overline{PC}$. The inverters 61 and 63 are provided with a precharge voltage signal PC. As may now be noted, a precharged signal PC is used for precharging P-channel dynamic logic structures while the precharge voltage $\overline{PC}$ is used for precharging N-channel dynamic logic structures.

In addition to the inputs K and $\overline{PC}$ the inverter 60 is further provided with an evaluation signal E. As will be described below the evaluation signal E is provided for initiating the operation of the inverters 60 - 63 following the precharging of the inverters and the application of an input signal to the input K of the inverter 60.

Referring to Fig. 13 there is provided, in accordance with the present invention, in the inverter 60 coupled in series between a source of positive voltage +V and ground, a PMOS transistor T70 and a pair of NMOS transistors T71 and T72. Coupled to the gate of the transistor T70 there is provided a precharged voltage $\overline{PC}$ coupled to the gate of the transistor 71 there is provided the input K. Coupled to the gate of the transistor 72 there is provided the evaluation signal E. The output of the inverter 60 is taken from a nodal point located between the transistor T70 and the transistors T71 and T72.

In the inverter 61 there is provided, coupled in series between a source of positive voltage +V and ground, a PMOS transistor T73 and an NMOS transistor T74. The input L of the inverter 61 is coupled to the gate of the transistor T73 and the output of the inverter 60. The precharge of voltage PC is coupled to the gate of the transistor T74.

In the inverter 62 there is provided, coupled in series between a source of positive voltage +V and ground, a PMOS transistor T75 and an NMOS transistor T76. The source of precharge voltage $\overline{PC}$ is coupled to the gate of the transistor T75, and the input M of the inverter 62 is coupled to the gate of the transistor T76 and the output of the inverter 61.

In the inverter 63 there is provided, coupled in series between a source of positive voltage +V and ground, a PMOS transistor T77 and an NMOS transistor T78. The gate of the transistor T78 is coupled to the precharge voltage PC and the N input of the inverter 63 is coupled to the gate of the transistor T77 and the output of the inverter 62.

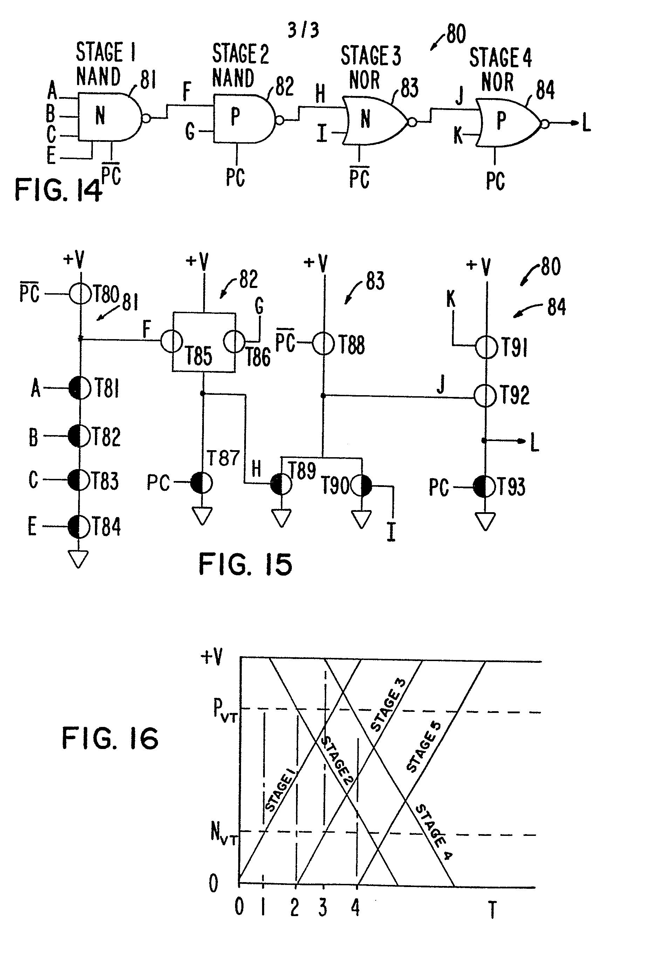

Referring to Fig. 14, there is provided, in accordance with the present invention, a complex dynamic logic circuit 80. In the logic circuit 80 there is provided a multiple input dynamic N-channel NAND gate 81, a multiple input dynamic P-channel NAND gate 82, a multiple input dynamic N-channel NOR gate 83 and a multiple input dynamic P-channel NOR gate 84. The NAND gate 81 is provided with three inputs A, B and C, an evaluation signal input E and a precharge voltage input $\overline{PC}$. The NAND gate 82 is provided with a pair of inputs F and G and a precharge voltage input PC. The NOR gate 83 is provided with a pair of inputs H and I and a precharge voltage input $\overline{PC}$. The NOR gate 84 is provided with a pair of inputs J and K, a precharge voltage PC and an output L. The output of the NAND gate 81 is coupled to the input F of the NAND gate 82. The output of the NAND gate 82 is coupled to the input H of the NOR gate 83 and the output of the NOR gate 83 is coupled to the J input of the NOR gate 84.

Referring to Fig. 15 there is provided a schematic of the dynamic logic structures of Fig. 14. In stage 1 there is provided in the NAND gate 81, coupled in series between a source of positive voltage +V and ground, a PMOS transistor T80 and a plurality of NMOS transistors T81, T82, T83 and T84. The precharge voltage $\overline{PC}$ is coupled to the gate of the transistor T80. The inputs A, B, C and E are respectively coupled to the gate of the transistors T81, T82, T83 and T84.

In stage 2 there is provided in the NAND gate 82, coupled between a source of positive voltage +V and ground, a pair of PMOS transistors T85 and T86. The transistors T85 and T86 are coupled in a series with an NMOS transistor T87. The F and G inputs of the NAND gate 82 are coupled respectively to the gates of the transistors T85 and T86. The precharge voltage PC is coupled to the gate of the transistor T87.

In stage 3, there is provided in the NOR gate 83, coupled between a source of positive voltage +V and ground, a PMOS transistor T88. Coupled in series with the transistor T88 there is provided a pair of parallel coupled NMOS transistors T89 and T90. The source of precharge voltage $\overline{PC}$ is coupled to the gate of the transistor T88. The input H is coupled to the gate of the transistor T89 and the input I is coupled to the gate of the transistor T90.

In stage 4, there is provided in the NOR gate 84, coupled in series between a source of positive voltage +V and ground, a plurality of PMOS transistors T91 and T92. Coupled in series with the transistors T91 and T92 there is provided an NMOS transistor T93. Input K is coupled to the gate of the transistor T91 and the input J is coupled to the transistor T92. The source of precharge voltage PC is coupled to the gate of transistor T93.

The input F to the NAND gate 82 is taken from a nodal point located between the transistors T80 and T81 of the NAND gate 81. The input H of the NOR gate 83 is taken from a nodal point located between the transistors T85 and T86 and the transistor T87 of the NAND gate 82. The input J of the NOR gate 84 is taken from a nodal point located between the transistor T88 and the transistors T89 and T90 of the NOR gate 83. The output L is taken from a nodal point between the transistors T92 and T93. Input G of the NAND gate 82, the input I of the NOR gate 83 and the input K of the NOR gate 84 are taken from the outputs of other dynamic logic structures, not shown.

In the dynamic logic structures described with respect to Figs. 1, 5, 6, 8, 9, 12, 13 and 14, the precharged voltage PC and the $\overline{PC}$ are generated from a clock using the inverter 5 described above with respect to Fig. 2. The PC clock will precharge all the P channel logic structures to a "0" level and the $\overline{PC}$ clock will precharge all of the N channel logic structures to a "1" level. All N channel and P channel structures are precharged at the same time. Notice that each stage precharges to the inactive level for its fanout.

After the PC clock is terminated all stages float in their precharge condition until the evaluation signal E, coupled to an input of the first stage of each of the dynamic logic circuits described above, occurs. When the E clock occurs, stage 1 begins to evaluate. If the input conditions on the remaining inputs to the first stage are correct for stage 1 to evaluate, it will evaluate from its precharged state to a "0" level which is the active state for stage 2. Assuming that the input conditions for each of the succeeding stages are met, all succeeding stages will begin to evaluate as the output of each stage moves through the threshold of the succeeding stage.

In addition to the obvious advantage of being able to implement multiple levels of logic, there is also a significant speed advantage because each stage only has to move a voltage equivalent to Vt of the next stage before each succeeding stage begins to evaluate.

Referring to Fig. 16 there is shown in a timing diagram voltage levels ranging from 0 to the positive voltage +V versus time. On the lower part of the diagram there is provided a threshold line designated $N_{Vt}$. In the upper part of the diagram there is provided a threshold line $P_{Vt}$. The lines $N_{Vt}$ and $P_{Vt}$ designate respectively the voltage thresholds of the input transistor of the N and P channel dynamic logic structures respectively. In the body of the diagram there is provided a plurality of parallel diagonal lines designated Stage 1, Stage 2, Stage 3, Stage 4 and Stage 5. The line designated Stage 1 represents the increase in voltage of the evaluation signal E applied to the first stage in each of the dynamic logic structures at a time T equals 0. The line designated Stage 2 represents the voltage output of Stage 1 and the input voltage applied to Stage 2. The line designated Stage 3 represents the voltage output of Stage 2 and the input voltage applied to Stage 3. The line designated Stage 4 represents the voltage output of Stage 3 and the voltage applied to the input of Stage 4. Similarly, the line designated Stage 5 represents the voltage output of Stage 4 and the voltage applied to the input of Stage 5, and so on.

As the voltage E rises towards the positive voltage +V, it crosses the N-channel voltage threshold as shown by the intersection of the diagonal line designated Stage 1 and the horizontal line designated $N_{Vt}$. As the voltage at the output of Stage 1 crosses the N-channel voltage threshold, the second stage begins to move with a corresponding drop in its output voltage as represented by the diagonal line designated Stage 2. When the output of the second stage reaches the P-channel voltage threshold, the output of the third stage begins to rise until it reaches the N-channel voltage threshold as is shown by the diagonal line designated Stage 3. When the output of Stage 3 reaches the N-channel voltage threshold the output of the fourth stage begins to drop as shown by the diagonal line designated Stage 4. When the output of Stage 4 drops to the P-channel voltage threshold the output of the Stage 5 begins to rise as shown by the diagonal line designated Stage

0082773

5. Since each stage only has to move from its precharged stage through one voltage threshold transistion before the next stage is activated, it is easy to see how the circuits according to the present invention can be very fast.

While a number of embodiments of the present invention are disclosed and described above, it is contemplated that many other circuits, both simple and complex, may incorporate the present invention and that various changes may be made to the embodiments disclosed and described without departing from the spirit and scope of the present invention. Accordingly it is intended that the present invention not be limited to the embodiments disclosed and described but be determined by reference to the claims hereinafter provided and their equivalents.

**0082773**

1.      A method of making a dynamic logic circuit characterized by the steps of:

> providing in each one of a plurality of logic structures of a first and a second conductivity type, a means for precharging said logic structure; providing in each one of said logic structures a means for changing said logic structure from a precharged state to an active state; coupling said changing means of one of said plurality of logic structures, other than a first one of said logic structures, of said first conductivity type to an output of one of said plurality of logic structures of said second conductivity type so that said logic structures of said first and said second conductivity type are coupled alternately in series; providing in said changing means of said first one of said logic structures of said first conductivity type a means responsive to an evaluation signal for changing said first one of said logic structures of said first conductivity type and succeeding logic structures of said first and said second conductivity type from their precharged state to their active state.

2.      The method of Claim 2 characterized in that said step of providing said changing means comprises the step of:

> providing in said changing means in said first one of said logic structures of said first conductivity type, a means responsive to said evaluation signal and a predetermined input signal for changing said first one of said logic structures from its precharged state to its active state; and
>
> providing in said changing means in the remaining ones of said plurality of logic structures of said first conductivity type and said logic structures of said second conductivity type, means responsive to a predetermined output received from the preceding logic structure coupled thereto and a predetermined input signal for changing said remaining ones of said plurality of logic structures of said first conductivity type and said logic structure of said second conductivity type from their precharged state to their active state.

3. A dynamic logic circuit characterized by: means in each one of a plurality of logic structures of a first and a second conductivity type for precharging said logic structure; means for changing said logic structures from a precharged state to an active state; means for coupling said plurality of logic structures, other than a first one of said logic structures, of said first conductivity type to an output of one of said plurality of logic structures of said second conductivity type so that said logic structures of said first and said second conductivity types are coupled alternately in series; means, in said changing means of said first one of said logic structures of said first conductivity type, responsive to an evaluation signal for changing said first one of said logic structures of said first conductivity type and succeeding logic structures of said first and said second conductivity type from their precharged state to their active state.

4. The circuit of claim 3 characterized in that said changing means in said first one of said logic structures of said first conductivity type comprises a means responsive to said evaluation signal and predetermined input signal for changing said first one of said logic structures from its precharged state to its active state; and said changing means in the remaining ones of said plurality of logic structures of said first conductivity type and said logic structures of said second conductivity type, comprise means responsive to a predetermined output received from the preceding logic structure coupled thereto and a predetermined input signal for changing said remaining ones of said plurality of logic structures of said first conductivity type and said logic structure of said second conductivity type from their precharged state to their active state.

5. The circuit of claim 3 characterized in that a first logic structure of said plurality of logic structures is of a first conductivity type and has a first input means for receiving a first input signal, a second input means for receiving an evaluation signal, a means for precharging said first logic structure to a precharged state, means responsive to said first input signal and said evaluation signal for changing the state of said structure from said precharged state to an active state, an ouput, and means responsive to a change of state of said first logic structure from said precharge state to said active state for providing an output signal on said output of said first logic structure; and in that a second logic structure of said plurality of logic structures is of a second conductivity type and has an input means for receiving said output signal, means separate from said input of said second logic structure for precharging said second logic structure to a precharged state, means for coupling said output of said first logic structure to said second input of said second logic structure, means responsive to said input signal received by said second logic structure for changing the state of said second logic structure from said precharged state to an active state; an output; and means responsive to a change of state of said second logic structure from said precharged state to said active state for providing an output signal on said output of said second logic structure.

6. The circuit of claim 5 characterized in that one of said first and said second logic structures is a P-channel logic structure and the other of said logic structures is an N-channel logic structure.

7.     The circuit of Claim 5 or 6 characterized in that said output signal on said output of said second logic structure comprises a third evaluation signal, and comprising:

a third logic structure of said first conductivity type having an input means for receiving an input signal, for receiving said evaluation signal from said second logic structure, means separate from said input means of said third logic strucutre for precharging said third logic structure to a precharged state, means for coupling said output of said second logic structure to said input means of said third logic structure;

means responsive to said input signal received by said third logic structure for changing the state of said third logic structure from said precharged state to an active state; and means responsive to a change of state of said third logic structure from said precharged state to said active state for providing an output signal on said output of said third logic structure.

8.      The circuit Claim 5 or 7 characterized in that said first and third logic structures are P-channel logic structures and said second logic structure is an N-channel logic structure.

9.      The circuit of Claim 5 or 6, 7 or 8 characterized in that charging means comprises means for precharging each of said logic structures simultaneously.

10.      The circuit of Claim 7 characterized in that said first and third logic structures are N-channel logic structures and said second logic structure is a P-channel logic structure.

11.      The circuit of any one of Claims 5-10 characterized in that said first input means of predetermined ones of said first and said input means of predetermined ones of said second plurality of logic circuits comprises means for coupling a plurality of inputs to each of said predetermined ones of said structures.

0082773

1/3

FIG. 1

FIG.2

FIG.3

FIG. 4

FIG. 5

FIG. 6

FIG. 7

FIG. 8

FIG. 9

FIG.10

STAGE 1 40  STAGE 2 41  STAGE 3 42  STAGE 4 43

K — L — M — N — 0

FIG.11

+V 40 T45  +V 41 T47  +V 42 T49  +V 43 T51

K T44  L T46  M T48  N T50  0

FIG.12

K 60 N  L 61 P  M 62 N  N 63 P  0

E $\overline{PC}$  PC  $\overline{PC}$  PC

FIG.13

+V 60 T70  +V 61 T73  +V 62 T75  +V 63 T77

$\overline{PC}$ T70  L T73  $\overline{PC}$ T75  N T77  0

K T71  PC T74  M T76  PC T78

E T72

FIG. 14

FIG. 15

FIG. 16